# EUROPÄISCHE PATENTSCHRIFT

(11) **EP 2 692 955 B1**
(45) Veröffentlichungstag und Bekanntmachung des Hinweises auf die Patenterteilung: **04.12.2019**
(21) Anmeldenummer: 13003684.1
(22) Anmeldetag: 23.07.2013
(51) Int. Cl.: E03C 1/05, H03K 17/95

(54) **Elektronischer Betätigungsschalter für Wasserarmaturen**
Electronic activation button for water taps
Commutateur à actionnement électronique pour robinetteries d'eau

(30) Priorität: 30.07.2012 DE 102012014946
(43) Veröffentlichungstag der Anmeldung: 05.02.2014
(73) Patentinhaber: Grohe AG, 58675 Hemer (DE)
(72) Erfinder: Mielke, Achim, 32457 Porta Westfalica (DE); Woesthoff, Wulf, 58675 Hemer (DE); Faust, Günter, 58730 Fröndenberg (DE)

(56) Entgegenhaltungen:
- EP-A1- 2 218 839
- WO-A1-91/13494
- WO-A1-2009/103596
- WO-A2-2009/019731
- US-B1- 6 956 498

## Beschreibung

Die vorliegende Erfindung betrifft einen elektronischen Betätigungsschalter mit mindestens zwei Betätigungszuständen für Wasserarmaturen.

Derartige Betätigungsschalter kommen beispielsweise im Zusammenhang mit Geräten zur Wasseraufbereitung zum Einsatz, die eine Zapfung von Kaltwasser, Warmwasser und aufbereitetem Wasser ermöglichen. Solche Geräte werden beispielsweise unter der Markenbezeichnung Grohe Blue® vertrieben.

Nachteilig bei den bekannten Betätigungsschaltern ist, dass diese über mechanische Elemente zu betätigen sind, die verschiedene Rastpositionen einnehmen können. Aufgrund der damit einhergehenden erhöhten Toleranzen in den Rastpositionen ist eine aufwendige Kalibrierung der Elektronik für die jeweiligen Rastpositionen notwendig, um unterschiedliche Bedienzustände mit einem erforderlichen Mindestmaß an Zuverlässigkeit erkennen zu können. Zudem unterliegen bekannte Systeme einem erhöhten mechanischen Verschleiß.

Aus der WO 2009/103596 A1 ist eine Bedienungsvorrichtung für Sanitärobjekte bekannt, bei der ein Bedienelement mittels einer Hubbewegung von einer ersten in eine zweite Funktionsebene bringbar ist. Zusätzlich kann bei dieser Vorrichtung eine Drehbewegung mittels eines zweiten Sensors erfasst werden, der mechanisch, optisch, kapazitiv oder induktiv die Drehbewegung des Bedienelementes erfasst. Aufgabe der Erfindung ist es daher, die sich aus dem Stand der Technik ergebenden Probleme zu lösen und insbesondere einen vereinfachten und in seiner Zuverlässigkeit verbesserten Betätigungsschalter bereitzustellen.

Diese Aufgaben werden mit einem elektronischen Betätigungsschalter gemäß dem unabhängigen Anspruch 1 sowie mit einer Sanitärarmatur mit diesem Betätigungsschalter gemäß Anspruch 7 gelöst.

Weitere vorteilhafte Ausgestaltungen der Erfindung sind in den abhängig formulierten Patentansprüchen angegeben. Darüber hinaus werden die in den Patentansprüchen angegeben Merkmale in der Beschreibung näher präzisiert und erläutert.

Vorliegend wird die Aufgabe durch einen elektronischen Betätigungsschalter gemäß dem Anspruch 1 gelöst, der wenigstens einen Betätigungsabschnitt, einen Basisabschnitt und Führungsmittel für eine Relativbewegung der beiden Abschnitte zueinander aufweist, wobei die Führungsmittel als Relativbewegung eine Drehbewegung des Betätigungsabschnitts um eine Drehachse des Basisabschnitts zulassen, und der wenigstens einen einem Betätigungszustand zugeordneten Magneten aufweist, der im Verlauf der Relativbewegung zumindest zeitweise in einen Erfassungsbereich eines Sensors gelangt und einen Mindestabstand zu dem Sensor erreicht, wobei wahlweise in einem Abschnitt wenigstens ein Sensor und im anderen Abschnitt wenigstens zwei Magnete, die wenigstens unterschiedliche Feldstärken oder unterschiedliche Mindestabstände zum wenigstens einen Sensor aufweisen, oder in einem Abschnitt wenigstens zwei Sensoren und im anderen Abschnitt wenigstens ein Magnet angeordnet sind, wobei der wenigstens eine Magnet unterschiedliche Mindestabstände zu den wenigstens zwei Sensoren aufweist, und dass der wenigstens eine Sensor in einer ersten Normalenebene zur Drehachse angeordnet ist und die verwendeten Magnete so angeordnet sind, dass sie sich bei der Drehbewegung um die Drehachse auf einer kreisförmigen Bewegungsbahn bewegen und in wenigstens einer zweiten beabstandeten Normalenebene zur Drehachse angeordnet sind. Die Betätigungszustände dienen dazu, unterschiedliche Funktionen der Wasserarmatur zu aktivieren bzw. deaktivieren. Die Funktionen können beispielsweise die Erzeugung und Abgabe von Kaltwasser, Warmwasser, Mischwasser oder aufbereitetem Wasser sein. Die Aufbereitung des Wassers kann durch Filtration, Kühlung und/oder der Zugabe von Kohlendioxid, einer sogenannten Karbonisierung, erfolgen. Jede Art der Aufbereitung kann in Alleinstellung oder kombiniert mit den anderen Aufbereitungsarten eingesetzt werden. Insbesondere die Karbonisierung kann mit unterschiedlichen Anreicherungszuständen von Kohlendioxid im Wasser betrieben werden.

Mit einem erfindungsgemäß ausgestatteten Betätigungsschalter ist es durch die Bewegung der Abschnitte zueinander möglich unter Ausführung der durch die Führungsmittel vorgegebenen Relativbewegung entlang einer Relativbewegungsbahn mittels des Sensors diskret und gut zu unterscheidende Betätigungszustände zu erfassen. So können beispielsweise zwei Magnete mit unterschiedlichen Feldstärken in konstantem Abstand an einem Sensor vorbeigeführt werden. In diesem Fall erfasst der Sensor entweder kein Magnetfeld, ein Magnetfeld mit einer ersten magnetischen Feldstärke oder ein Magnetfeld mit einer zweiten magnetischen Feldstärke. Unter der zweiten magnetischen Feldstärke ist in diesem Zusammenhang jeweils das Maximum der sensierten Magnetfeldstärke beim Abfahren der Relativbewegungsbahn zu verstehen. Alternativ ist es bei einer anderen Ausführungsform möglich, einen einzigen Magneten zu verwenden und diesen an zwei Sensoren entlang zu bewegen, wobei beide Sensoren unterschiedliche Minimalabstände zu dem verwendeten Magnet einnehmen. Das bedeutet, der Magnet ist von der Bewegungsbahn der Sensoren oder die Sensoren sind von der Bewegungsbahn des Magneten in unterschiedlichen Mindestabständen angeordnet. Auch hierbei lassen sich wieder drei Betätigungszustände erfassen. Im ersten Zustand liegt der Magnet außerhalb eines Erfassungsbereichs des Sensors und es werden kein Magnet und keine magnetische Feldstärke sensiert. Im zweiten Zustand wird der Magnet dann vom ersten Sensor und im dritten Zustand vom zweiten Sensor sensiert. Durch die Verwendung von Magneten unterschiedlicher Feldstärken und alternativ oder zusätzlich die Verwendung unterschiedlicher Abstände zwischen Sensor und Magnet wird es möglich, klar voneinander getrennte Betätigungszustände zu sensieren, welche mit besonderer Zuverlässigkeit erfassbar sind. Darüber hinaus kann die Lebensdauer durch die Verwendung von Dauermagneten und bekannten Sensoren deutlich verbessert werden, da diese berührungslos und verschleißfrei arbeiten.

Es ist vorgesehen, dass die Führungsmittel als Relativbewegung eine Drehbewegung des Betätigungsabschnittes um eine Drehachse des vorzugsweise feststehenden Basisabschnittes zulassen. Eine Drehbewegung ist bei Armaturen allgemein bekannt und wird als ergonomisch vorteilhaft angesehen.

Darüber hinaus sind die Sensoren in einer ersten Normalenebene zur Drehachse und die Bewegungsbahn der verwendeten Magnete in wenigstens einer zweiten beabstandeten Normalenebene angeordnet. Bewegungsbahn bedeutet in diesem Zusammenhang, dass die Magnete durch die Führungsmittel auf einer Bewegungsbahn geführt werden, die dem Verlauf der Relativbewegung entspricht. Im Falle einer Drehbewegung ist die Bewegungsbahn kreisförmig. Die bezeichneten Normalenebenen liegen dabei in Normalenrichtung zur Drehachse und sind vorzugsweise parallel zueinander ausgerichtet. Während es für die Erfindung bereits ausreichend ist eine erste Normalenebene und eine zweite dazu beabstandete Normalenebene zu verwenden, können darüber hinaus auch Magnete in weiteren anders beabstandeten Normalenebenen angeordnet sein.

Vorteilhafterweise sind dabei die Magnete einzeln oder in Gruppen in den weiteren zweiten Normalenebenen angeordnet, die unterschiedliche Abstände zur ersten Normalenebene aufweisen. Durch die unterschiedlichen Abstände können am Sensor unterschiedliche sensierbare Feldstärken dargestellt werden. In Kombination mit der Verwendung von Magneten mit unterschiedlichen Magnetfeldstärken kann somit bei geeigneter Wahl von Abständen und Feldstärken eine deutlich verbesserte Unterscheidbarkeit der eingestellten Betätigungszustände erreicht werden. Selbstverständlich gilt es dabei zu beachten, dass bei einer Wahl von stärkeren Magneten der Zugewinn der sensierbaren magnetischen Feldstärke nicht durch einen entsprechend vergrößerten Mindestabstand zum Sensor kompensiert wird. Diese Wechselbeziehung zwischen der Feldstärke der gewählten Magnete und den auftretenden Abstände beziehungsweise Mindestabständen zwischen Magnet und Sensor beim Abfahren der Bewegungsbahn, stellt ein wesentliches Merkmal der vorliegenden Erfindung dar.

Vorteilhafterweise ist aufgrund der besonders günstigen Betätigungssituation der erfindungsgemäße Betätigungsschalter in einen Drehgriff der Wasserarmatur integriert.

Zur Verbesserung der haptischen Eigenschaften kann zudem vorgesehen werden, dass ein mechanisches Rastmittel in wenigstens einer Betätigungsstellung lösbar eingreift, bei der sich mindestens ein Magnet im Erfassungsbereich eines Sensors befindet. Dies gibt dem Bediener neben der ausgelösten Funktion der Armatur eine zusätzliche haptische Rückmeldung über das Erreichen der jeweiligen Betätigungsstellungen.

Weiterhin sieht die Erfindung eine elektrisch betätigbare Wasserarmatur mit wenigstens einem Zulauf und einer daran angeschlossenen elektronischen Steuerung vor, die sich dadurch auszeichnet, dass diese einen elektronischen Betätigungsschalter nach einem der vorhergehenden Ansprüche aufweist, der mit der elektronischen Steuerung verbunden ist. Mit dem erfindungsgemäßen elektronischen Betätigungsschalter kann eine solche Wasserarmatur detektierte Signale eines gewählten Betätigungszustands an eine elektronische Steuerung weiterleiten, die dazu geeignet ist dieses Signal zu verarbeiten und die gewünschten Funktionen zu steuern.

Vorzugsweise weist die elektronische Steuerung dazu eine Auswerteelektronik auf, die so ausgebildet ist, dass sie Maxima und Minima der sensierten magnetischen Feldstärken erfassen und diese zuverlässig den vorgegebenen diskreten Betätigungszuständen zuordnen kann. Werden die bei der Bewegung entlang der Bewegungsbahn durchlaufenen Maxima und Minima gezählt, ist diese Information neben der sensierten magnetischen Feldstärke zusätzlich auswertbar, um den jeweils vorgegebenen Betätigungszustand noch zuverlässiger zu bestimmen.

Schließlich kann die elektronische Steuerung vorteilhafterweise eine Auswerteelektronik umfassen, die die vom Sensor erzeugten Signale zur Ermittlung der Betätigungszustände auswertet und auf unterschiedliche Kennlinien der Signale einstellbar ist. Hierdurch ist es beispielsweise möglich fertigungsbedingte Toleranzen der vom Sensor gemessenen magnetischen Feldstärken oder Abweichungen der Kennlinie von einer Sollkennlinie erkannt und kompensiert werden, ohne dass weitere Maßnahmen erforderlich sind. Die Auswerteelektronik kann dazu mit bekannten Algorithmen programmiert sein, um entsprechende Auswertungen zu erhalten. Denkbar ist weiterhin auch die Verwendung von magnetischen Kodierungen, so daß beispielsweise ein Betätigungszustand erst nach Abfolge einer bestimmten magnetischen Kodierung nach Anzahl oder Polarität erkannt wird.

Nachfolgend werden die Erfindung sowie das technische Umfeld anhand der Figuren näher erläutert. Es ist darauf hinzuweisen, dass die Figuren besonders bevorzugte Ausführungsvarianten der Erfindung zeigen, auf die sie jedoch nicht beschränkt ist.

In der Zeichnung zeigen:
- Figur 1: eine erfindungsgemäße Wasserarmatur in einer Schrägansicht;
- Figur 2: eine Schnittansicht eines erfindungsgemäßen Betätigungsschalters;
- Figur 3: eine teilweise Schnittansicht der Wasserarmatur nach Figur 1;
- Figur 4: eine weitere Schnittansicht der Wasserarmatur nach Figur 1;
- Figur 5: eine Kennlinie eines Sensorsignals mit vier Betätigungszuständen; und
- Figur 6: eine Wasserarmatur nach Figur 1 ohne Betätigungsschalters.

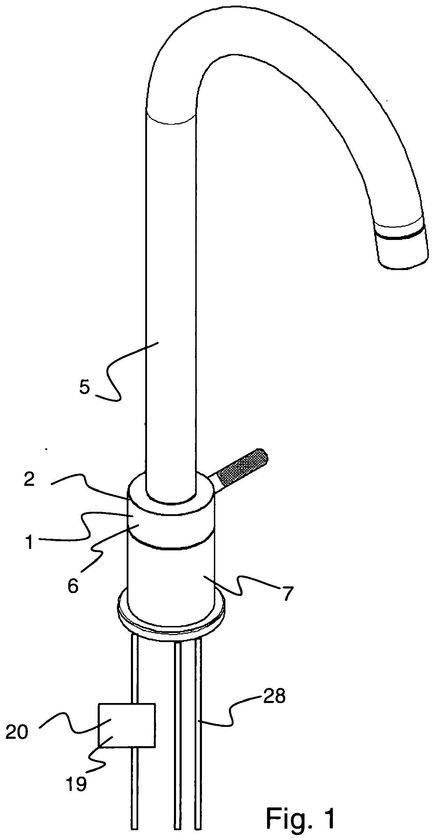

In Figur 1 ist ein erfindungsgemäßer Betätigungsschalter 1 in einem Betätigungszustand 2 an einer Wasserarmatur 5 dargestellt. Der Betätigungsschalter 1 besteht aus einem Betätigungsabschnitt 6, der drehbeweglich gegenüber einem Basisabschnitt 7 gelagert ist. Die Lagerung und Führung dieser Relativbewegung erfolgt durch innenliegende Führungsmittel 8.

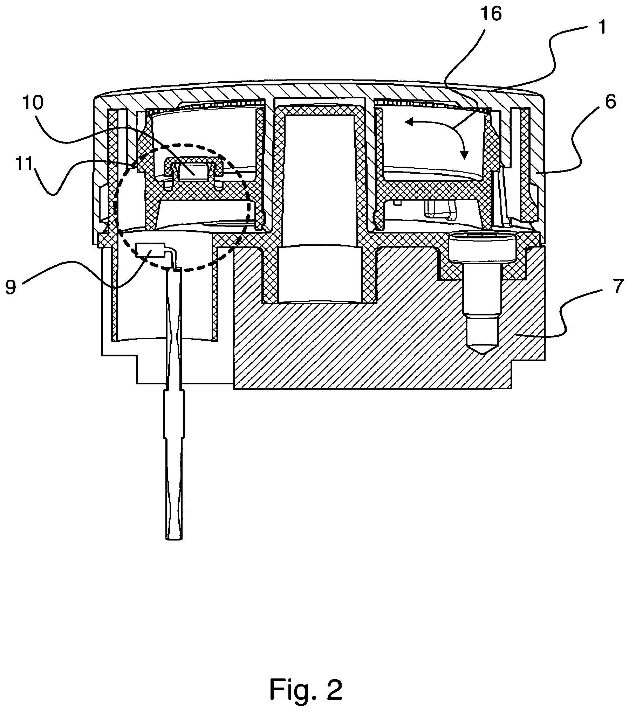

In Figur 2 ist eine Schnittdarstellung durch eine andere Ausführungsform eines erfindungsgemäßen Betätigungsschalter 1 dargestellt. Der kreisrunde Betätigungsabschnitt 6 ist hierbei drehbeweglich gegenüber dem Basisabschnitt 7 gelagert, wobei die in dieser Figur nicht dargestellten Führungsmittel 8 eine Drehbewegung um eine zum kreisrunden Betätigungsabschnitt 6 konzentrische Drehachse 13 ermöglichen. Im Basisabschnitt 7 ist ein Sensor 9 gezeigt, welcher einen Magnet 10 sensiert, welcher sich in seinem Erfassungsbereich 11 befindet. Der Magnet 10 ist am Betätigungsabschnitt 6 in einer Vertiefung angeordnet, die mittels einer Kappe verschlossen wird und den Magneten 10 so fixiert. Besonders vorteilhaft ist es, wenn die Anlagefläche des Magneten als Referenzfläche genutzt wird, um einen definierten Abstand zwischen Magnet 10 und Sensor 9 zu erzeugen. Dadurch kann der Magnet 10 einfach in die Vertiefung gelegt werden, wobei er an durch die Kappe gegen die Referenzfläche am Betätigungsabschnitt 6 positioniert gehalten wird. Alternativ können die Magnete 10 bei einer besonders einfachen Ausführungsform am Bestätigungsabschnitt 6 zur Anlage an der Referenzfläche gebracht und dort mittels eines Klebemittels fixiert werden. Als Referenzfläche kann beispielsweise der Boden einer Bohrung dienen, in die die Magnete 10 eingelegt werden. Die Fixierung ist anschließend durch ein wenigstens teilweises Auffüllen der Bohrung mit einem vorzugsweise flüssigen Klebemittel möglich, dass anschließend aushärtet. Dies erlaubt eine sehr schnelle Serienfertigung bei gleichzeit sehr geringen Fertigungstoleranzen. Daneben können in diesem Zusammenhang aber auch andere Klebemittel verwendet werden, die geeignet sind den Magnet 10 dauerhaft an einer Referenzfläche zu fixieren.

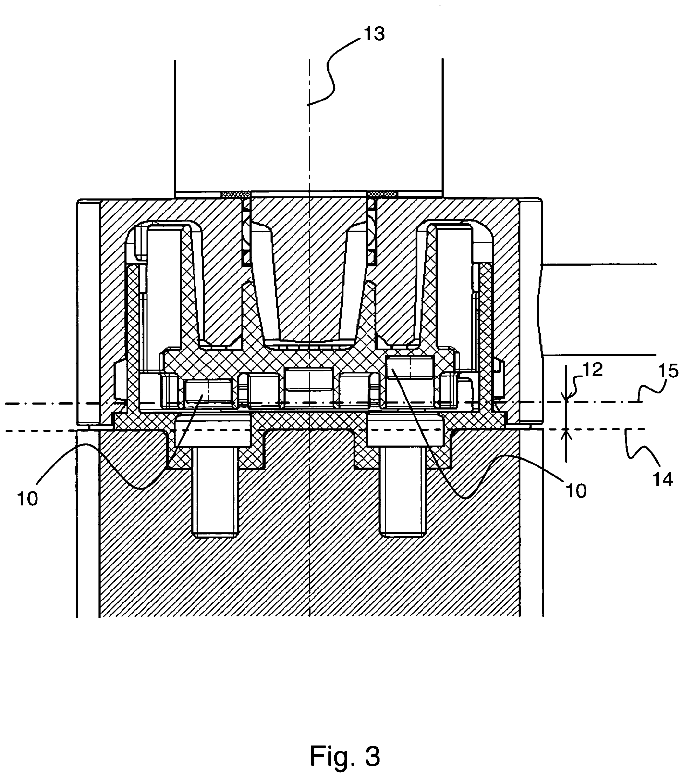

Die Figur 3 zeigt den erfindungsgemäßen Betätigungsschalter 1 nach Figur 1 in einer teilweisen Schnittdarstellung durch die Drehachse 13. Bei dieser Ausführungsform ist der in dieser Schnittdarstellung nicht gezeigte Sensor 9 in einer ersten Normalenebene 14 angeordnet und die Magnete 10 in einer zweiten Normalenebene 15, wobei die beiden parallelen Ebenen 14, 15 um einen Abstand 12 zueinander beabstandet sind. Die Magnete 10 sind so angeordnet, dass sie sich bei der Drehbewegung um die Drehachse 13 auf einer kreisförmig Bewegungsbahn bewegen und den Erfassungsbereich 11 des Sensors 9 durchlaufen. Gut erkennbar ist in dieser Figur auch, dass jeder der Magnete 10 einen anderen Mindestabstand zur ersten Normalenebene 14 aufweist, da sie in mehreren zweiten Normalenebenen 15 geführt sind, die verschiedene Ebenenabstände 12 zu ersten Normalenebene 14 haben.

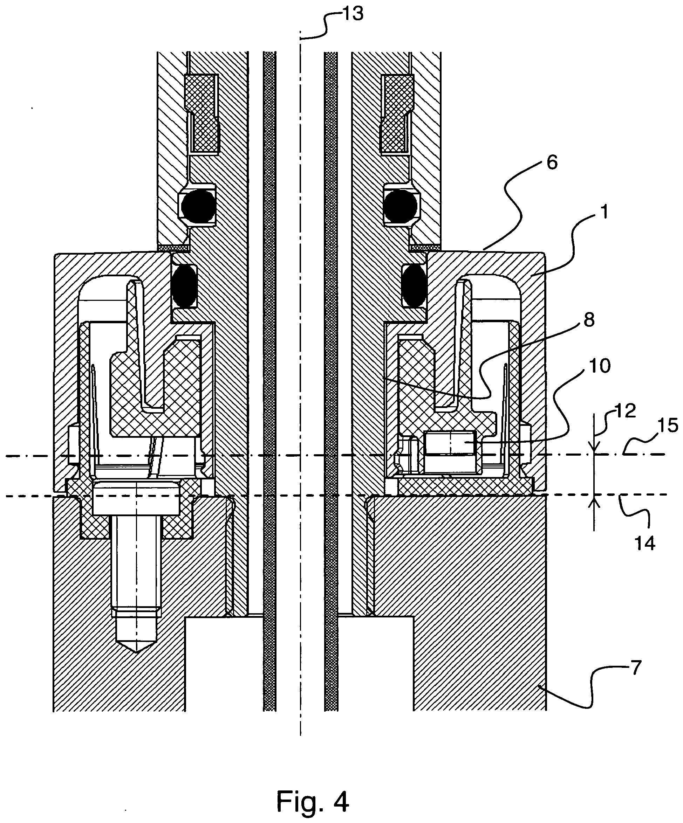

In Figur 4 ist der erfindungsgemäßen Betätigungsschalters 1 nach Figur 1 nochmals in einer anderen Schnittansicht dargestellt. Der Betätigungsabschnitt 6 ist durch Führungsmittel 8 relativ zum Basisabschnitt 7 um eine Drehachse 13 drehbeweglich gelagert. Bei dieser Ausführungsform sind die erste Normalenebene 14 und die zweite Normalenebene 15 um einen Anstand 12 voneinander beabstandet. Hierbei ist jedoch vorgesehen, dass jeder verwendete Magnet 10 und dessen jeweilige zweite Normalenebene 15 einen anderen Abstand 12 zur ersten Normalenebene 14 aufweist. Durch die individuellen Abstände 12 können die Unterschiede der sensierten magnetischen Feldstärken und damit die verschiedenen Betätigungszustände zuverlässiger erkannt werden. Während es bei dem Beispiel nach Figur 3 bei konstanten Abständen 12 erforderlich ist, Magnete mit ausreichend großen Feldstärkeunterschieden zu verwenden, die so groß sein müssen, dass eine Erkennung durch den Sensor 9 mit der erforderlichen Zuverlässigkeit erfolgt, können bei der Ausführungsform nach Figur 4 mit unterschiedlichen Abständen 12 sogar Magnete 10 mit gleichen magnetischen Feldstärken zur Anwendung kommen. Im einfachsten Fall werden dazu Magnete 10 mit gleichen magnetischen Feldstärken einfach nacheinander in unterschiedlichen Abständen 12 entlang der Kreisbahn 16 durch den Erfassungsbereich 11 des Sensors 9 geführt. Bereits hierdurch werden hinreichend unterschiedliche Feldstärken am Sensor 9 sensiert. Zusätzlich verstärkt werden kann dieser Effekt noch, indem kombiniert mit den unterschiedlichen Abständen 12 Magnete 10 mit unterschiedlichen magnetischen Feldstärken eingesetzt werden. Hierbei ist lediglich darauf zu achten, dass beispielsweise eine Reduzierungen der sensierten magnetischen Feldstärke aufgrund eines größeren Abstandes 12 durch die Verwendung von Magneten 10 mit größerer magnetischer Feldstärke kompensiert werden, so dass eine Detektion durch den Sensor 9 nicht mehr zuverlässig möglich ist. Vielmehr kann bei umgekehrter Vorgehensweise durch die geeignete Wahl der Abstände 12 und der magnetischen Feldstärken der Magnete 10 die Detektion durch den Sensor 9 und die damit einhergehende Unterscheidbarkeit der verschiedenen Betätigungszustände deutlich verbessert werden.

Grundsätzlich ist vorgesehen, dass jeder Magnet 10 einem Betätigungszustand 2 zugeordnet ist. Durch die Verwendung weiterer Magnete 10 können aber auch zweite Betätigungszustände 3 und dritte Betätigungszustände 4 sowie beliebige weitere Betätigungszustände realisiert werden. Grundsätzlich existiert bei allen Ausführungsformen jeweils noch ein weiterer Betätigungszustand 2, bei welchem kein Magnet im Erfassungsbereich 11 des Sensors verweilt. Die Anzahl der erfassbaren Betätigungszustände 2 entspricht somit der Anzahl der verwendeten Magnete 10 plus einem weiteren Betätigungszustand 2.

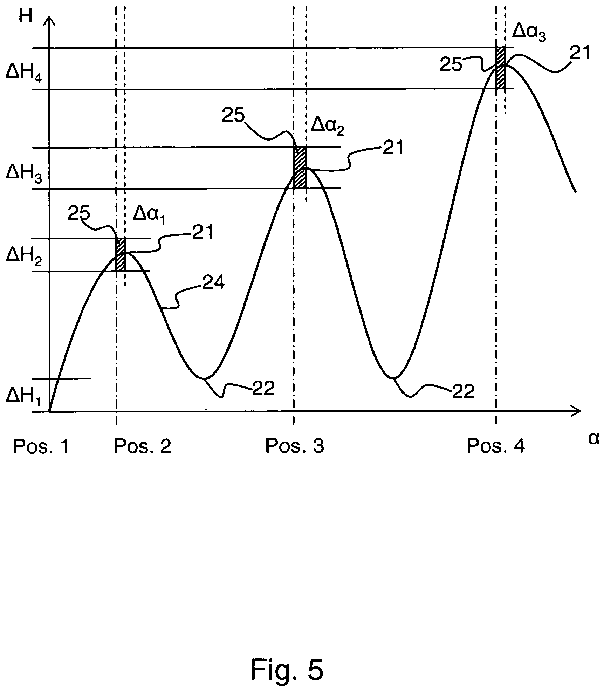

In Figur 5 ist die vom Sensor 9 erfasste magnetische Feldstärke gegenüber einem Drehwinkel α des Betätigungsabschnitts 6 graphisch dargestellt. Befinden sich der Betätigungsabschnitt 6 in der Ausgangslage und kein Magnet 10 im Erfassungsbereich 11 des Sensors 9, so wird die Position 1 mit keiner oder nur einer sehr geringen magnetischen Feldstärke sensiert. Dies entspricht dem Bereich ΔH₁ der magnetischen Feldstärke H. Beim Drehen des Betätigungsabschnitts 6 gelangt anschließend ein erster Magnet 10 in den Erfassungsbereich 11 des Sensors 9 und erzeugt ein Maxima 21 im Bereich ΔH₂. Die Winkellage des Maximums 21 ist mit einer vertikal gestrichelten Linie dargestellt, die zu der theoretisch vorgesehenen Solllage, welche mit einer vertikalen strichpunktierten Linie gekennzeichnet ist, versetzt. Ein solcher Versatz Δα entsteht beispielsweise durch Fertigungstoleranzen in der mechanischen Komponente oder aber auch durch Toleranzen der verwendeten elektronischen Bauteile. Im weiteren Verlauf der Kennlinie 24 wird vom Sensor 9 dann ein Minimum 22 detektiert, bevor ein weiteres Maximum 21 und ein weiteres Minimum 22 detektiert werden. Das zweite Maximum 21 hat dabei aber eine höhere magnetische Feldstärke Bereich ΔH₃ als das Maximum 21, welches zuvor im Bereich ΔH₂ der Position 2 sensiert worden ist. Hierdurch kann eine verwendete Auswerteelektronik zuverlässig erkennen, dass eine weitere Position 3 erreicht worden ist. Das Gleiche gilt auch für die dargestellte Position 4, die ein nochmals erhöhtes Maximum 21 mit einer wiederum erhöhten magnetischen Feldstärke im Bereich von ΔH₄ aufweist. Die Auswerteelektronik 20 kann mit geeigneter und bekannter Software betrieben werden, die im Stand der Technik ausreichend verfügbar ist. Die Parametrierung der Software ist so gewählt, dass die Erkennung von Betätigungszuständen 2 in besonders zuverlässiger und einfacher Weise erfolgt, indem Signalzustände innerhalb eines Kennlinienfensters 25 toleranzstabil erkannt und den Betätigungszuständen 2, 3, 4 entsprechenden Positionen 1 - 4 zugeordnet werden. Mit Hilfe der Kennlinienfenster 25 ist es somit möglich, durch Fertigung und Veränderungen über die Lebensdauer des Betätigungsschalters 1 bedingte Toleranzen in zuverlässiger Weise zu kompensieren.

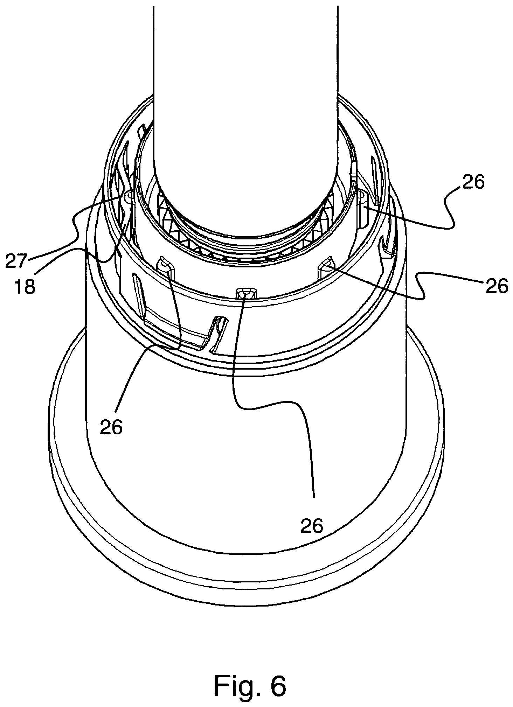

In Figur 6 ist schließlich ein Rastmittel 18 dargestellt, welches einem Bediener des Betätigungsschalters 1 eine haptische Rückmeldung über das Erreichen verschiedener Betätigungszustände 2, 3, 4 liefert. Hierzu sind an verschiedenen Positionen Nocken 26 vorgesehen, welche jeweils Betätigungszuständen entsprechen. Die Nocken 26 überstreichen im Verlauf einer Drehbewegung das Rastmittel 18 und gleiten in eine Rastmulde 27, die elastisch federnd und verformbar ist. Der Widerstand, der bei der elastischen Verformung der Rastmulde 27 aufzubringen ist, sowie die Fixierung innerhalb der Rastmulde 27 geben dem Bediener eine zuverlässige Rückmeldung über das Erreichen der bestimmten diskreten Betätigungszustände 2, 3, 4. Gut erkennbar ist bei der Darstellung nach Figur 6, dass die Rastmulde 27 in radialer Richtung nach außen verformbar ist, um die erforderliche Verformbarkeit zu erreichen.

### Bezugszeichenliste:

- 1: Betätigungsschalter
- 2: Betätigungszustand
- 3: zweiter Betätigungszustand
- 4: dritter Betätigungszustand
- 5: Wasserarmatur
- 6: Betätigungsabschnitt
- 7: Basisabschnitt
- 8: Führungsmittel
- 9: Sensor
- 10: Magnet
- 11: Erfassungsbereich
- 12: Abstand
- 13: Drehachse
- 14: erste Normalenebene
- 15: zweite Normalenebene
- 16: Kreisbahn
- 17: Drehgriff
- 18: Rastmittel
- 19: Steuerung
- 20: Auswerteelektronik
- 21: Maxima
- 22: Minima
- 23: Signal
- 24: Kennlinie
- 25: Kennlinienfenster
- 26: Nocke
- 27: Rastmulde
- 28: Zulauf

## Patentansprüche

1. Elektronischer Betätigungsschalter (1) mit mindestens zwei Betätigungszuständen (2, 3, 4) für Wasserarmaturen (5),
der wenigstens einen Betätigungsabschnitt (6), einen Basisabschnitt (7) und Führungsmittel (8) für eine Relativbewegung der beiden Abschnitte (6, 7) zueinander aufweist, wobei die Führungsmittel (8) als Relativbewegung eine Drehbewegung des Betätigungsabschnitts (6) um eine Drehachse (13) des Basisabschnitts (7) zulassen, und
der wenigstens einen einem Betätigungszustand (2, 3, 4) zugeordneten Magneten (10) aufweist, der im Verlauf der Relativbewegung zumindest zeitweise in einen Erfassungsbereich (11) eines Sensors (9) gelangt und einen Mindestabstand zu dem Sensor (9) erreicht,
**dadurch gekennzeichnet, dass**
wahlweise in einem Abschnitt (6, 7) wenigstens ein Sensor (9) und im anderen Abschnitt (6, 7) wenigstens zwei Magnete (10), die wenigstens unterschiedliche magnetische Feldstärken oder unterschiedliche Mindestabstände zum wenigstens einen Sensor (9) aufweisen, oder
in einem Abschnitt (6, 7) wenigstens zwei Sensoren (9) und im anderen Abschnitt (6, 7) wenigstens ein Magnet (10) angeordnet sind, wobei der wenigstens eine Magnet (10) unterschiedliche Mindestabstände zu den wenigstens zwei Sensoren (9) aufweist, und dass
der wenigstens eine Sensor (9) in einer ersten Normalenebene (14) zur Drehachse (13) angeordnet ist und die verwendeten Magnete (10) so angeordnet sind, dass sie sich bei der Drehbewegung um die Drehachse (13) auf einer kreisförmigen Bewegungsbahn bewegen und in wenigstens einer zweiten beabstandeten Normalenebene (15) zur Drehachse (13) angeordnet sind.

2. Elektronischer Betätigungsschalter (1) nach Anspruch 1, **dadurch gekennzeichnet, dass** die Magnete (10) einzeln oder in Gruppen in weiteren zweiten Normalenebenen (15) angeordnet sind, die unterschiedliche Abstände (12) zur ersten Normalenebene (14) aufweisen.

3. Elektronischer Betätigungsschalter (1) nach einem der vorhergehenden Ansprüche, **dadurch gekennzeichnet, dass** wenigstens ein Magnet (10) und wenigstens zwei Sensoren (9) mit unterschiedlichen Abständen (12) vorgesehen sind.

4. Elektronischer Betätigungsschalter (1) nach einem der vorhergehenden Ansprüche, **dadurch gekennzeichnet, dass** wenigstens ein Magnet (10) in einer ersten Normalenebene (14) und wenigstens zwei Sensoren (9) kreisbahnförmig in wenigstens zwei zweiten Normalenebenen (15) mit unterschiedlichen Abständen (12) zur ersten Normalenebene (14) angeordnet sind.

5. Elektronischer Betätigungsschalter (1) nach einem der vorhergehenden Ansprüche, **dadurch gekennzeichnet, dass** der Betätigungsschalter (1) in einen Drehgriff (17) der Wasserarmatur (5) integriert ist.

6. Elektronischer Betätigungsschalter (1) nach einem der vorhergehenden Ansprüche, **dadurch gekennzeichnet, dass** zusätzlich ein mechanisches Rastmittel (18) in wenigstens einer Drehstellung vorgesehen ist, bei der sich mindestens ein Magnet (10) im Erfassungsbereich (11) eines Sensors (9) befindet.

7. Elektrisch betätigbare Wasserarmatur (5) mit wenigstens einem Zulauf (28) und einer daran angeschlossen elektronischen Steuerung (19), **dadurch gekennzeichnet, dass** diese einen elektronischen Betätigungsschalter (1) nach einem der vorhergehenden Ansprüche aufweist, der mit der elektronischen Steuerung (19) verbunden ist.

8. Elektrisch betätigbare Wasserarmatur (5) nach Anspruch 7, **dadurch gekennzeichnet, dass** die elektronische Steuerung (19) eine Auswerteelektronik (20) umfaßt, die dazu ausgebildet ist, Maxima und Minima der magnetischen Feldstärke zu erfassen und sie diskreten Bestätigungszuständen (2, 3, 4) zuzuordnen.

## Claims

1. An electronic activation button (1) having at least two activation states (2, 3, 4) for water taps (5), which has at least one activation section (6), a base section (7) and guide means (8) for a movement of the two sections (6, 7) relative to each other, wherein as a relative movement, the guide means (8) permit a rotary movement of the activation section (6) about a rotation axis (13) of the base section (7), and
which has at least one magnet (10) associated with an activation state (2, 3, 4), which in the course of the relative movement comes at least intermittently within a range (11) of a sensor (9) and reaches a minimum distance to the sensor (9),
**characterized in that**
at least one sensor (9) is selectively arranged in one section (6, 7) and at least two magnets (10), which have at least varying magnetic field strengths or varying minimum distances to the at least one sensor (9), are selectively arranged in the other section (6, 7), or
at least two sensors (9) are arranged in one section (6, 7) and at least one magnet (10) is arranged in the other section (6, 7), the at least one magnet (10) having varying minimum distances to the at least two sensors (9), and that
the at least one sensor (9) is arranged in a first normal plane (14) to the rotation axis (13) and the magnets (10) that are used are arranged such that during the rotary movement about the rotation axis (13), they move in a circular orbit and are arranged in at least one second normal plane (15) distanced from the rotation axis (13).

2. The electronic activation button (1) according to Claim 1, **characterized in that** the magnets (10) are arranged singly or in groups in further second normal planes (15), which have varying distances (12) to the first normal plane (14).

3. The electronic activation button (1) according to any one of the preceding claims, **characterized in that** at least one magnet (10) and at least two sensors (9) with varying distances (12) are provided.

4. The electronic activation button (1) according to any one of the preceding claims, **characterized in that** at least one magnet (10) is arranged in a first normal plane (14) and at least two sensors (9) are arranged orbitally in at least two second normal planes (15) with varying distances (12) to the first normal plane (14) .

5. The electronic activation button (1) according to any one of the preceding claims, **characterized in that** said activation button (1) is integrated in a turning handle (17) of the water tap (5).

6. The electronic activation button (1) according to any one of the preceding claims, **characterized in that** in addition, a mechanical catch means (18) is provided in at least one turning position, in which at least one magnet (10) is situated within the range (11) of a sensor (9).

7. An electrically activatable water tap (5) having at least one inlet (28) and an electronic control (19) connected thereto, **characterized in that** said tap has an electronic activation button (1) according to any one of the preceding claims, which is connected to the electronic control (19).

8. The electrically activatable water tap (5) according to Claim 7, **characterized in that** the electronic control (19) comprises an electronic evaluation unit (20), which is configured to detect maxima and minima of the magnetic field strength and to assign them to discrete activation states (2, 3, 4).

## Revendications

1. Commutateur d'actionnement électronique (1) comprenant au moins deux états d'actionnement (2, 3, 4), destiné à des robinetteries d'eau (5),
lequel comporte au moins une partie d'actionnement (6), une partie de base (7) et des moyens de guidage (8) pour un déplacement relatif des deux parties (6, 7) l'une par rapport à l'autre, les moyens de guidage (8) admettant en tant que déplacement relatif un déplacement en rotation de la partie d'actionnement (6) autour d'un axe de rotation (13) de la partie de base (7), et
lequel comporte au moins un aimant (10) associé à un état d'actionnement (2, 3, 4), qui au cours du déplacement relatif arrive au moins temporairement dans une zone de détection (11) d'un capteur (9) et atteint un écart minimum par rapport au capteur (9), **caractérisé en ce que** sélectivement, dans une partie (6, 7) est placé au moins un capteur (9) et dans l'autre partie (6, 7) sont placés au moins deux aimants (10), qui présentent au moins deux différentes intensités de champ magnétique ou différents écarts minima par rapport à l'au moins un capteur (9), ou dans une partie (6, 7) sont placés au moins deux capteurs (9) et dans l'autre partie (6, 7) est placé au moins un aimant (10), l'au moins un aimant (10) présentant différents écarts minima par rapport aux au moins deux capteurs (9) et **en ce que**
l'au moins un capteur (9) est placé dans un premier plan normal (14) par rapport à l'axe de rotation (13) et les aimants (10) utilisés sont placés de telle sorte que lors du déplacement en rotation autour de l'axe de rotation (13), ils se déplacent sur une trajectoire de déplacement circulaire et soient placés dans au moins un deuxième plan normal (15) écarté par rapport à l'axe de rotation (13).

2. Commutateur d'actionnement électronique (1) selon la revendication 1, **caractérisé en ce que** les aimants (10) sont placés individuellement ou en groupes dans d'autres deuxièmes plans normaux (15), qui présentent différents écarts (12) par rapport au premier plan normal (14).

3. Commutateur d'actionnement électronique (1) selon l'une quelconque des revendications précédentes, **caractérisé en ce qu'**au moins un aimant (10) et au moins deux capteurs (9) sont prévus avec différents écarts (12).

4. Commutateur d'actionnement électronique (1) selon l'une quelconque des revendications précédentes, **caractérisé en ce qu'**au moins un aimant (10) est placé dans un premier plan normal (14) et au moins deux capteurs (9) sont placés en forme de trajectoire circulaire dans au moins deux deuxièmes plans normaux (15) présentant différents écarts (12) par rapport au premier plan normal (14).

5. Commutateur d'actionnement électronique (1) selon l'une quelconque des revendications précédentes, **caractérisé en ce que** le commutateur d'actionnement (1) est intégré dans une poignée rotative (17) de la robinetterie d'eau (5).

6. Commutateur d'actionnement électronique (1) selon l'une quelconque des revendications précédentes, **caractérisé en ce qu'**il est prévu additionnellement un moyen d'enclenchement mécanique (18) dans au moins une position en rotation, dans laquelle au moins un aimant (10) se trouve dans la zone de détection (11) d'un capteur (9).

7. Robinetterie d'eau (5) à actionnement électrique, comprenant au moins une arrivée (28) et un système de commande électronique (19) raccordé sur celle-ci, **caractérisée en ce qu'**elle comporte un commutateur d'actionnement électronique (1) selon l'une quelconque des revendications précédentes, qui est connecté sur le système de commande électronique (19).

8. Robinetterie d'eau (5) à actionnement électrique selon la revendication 7, **caractérisée en ce que** le système de commande électronique (19) comporte une électronique d'évaluation (20) qui est conçue pour détecter des maxima et des minima de l'intensité de champ magnétique et les associer à des états d'actionnement (2, 3, 4) discrets.
